# EUROPEAN PATENT APPLICATION

(11) **EP 4 768 304 A1**
(43) Date of publication of application: **01.07.2026**
(21) Application number: 25221212.1
(22) Date of filing: 05.12.2025
(51) Int. Cl.: B60L 3/00, B60L 3/04, H01R 12/58, H01R 31/06, H02H 9/06, H02J 7/02, H05K 1/14, H05K 1/18

(54) **A CHARGING ASSEMBLY FOR AN ELECTRIC VEHICLE**

(30) Priority: 19.12.2024 IN 202421100825
(71) Applicant: Hella Emobionics Pvt. Ltd, Pune 411045 MAH (IN)
(72) Inventor: KALANTRI, Kapil Laxminarayan, 411045 Pune (IN); ANSARI, Nafees Mazeed, 410506 Pune (IN); DESHPANDE, Rohan Jayant, 411068 Pune (IN); YADAV, Dhananjay Dilip, 411057 Pune (IN)
(74) Representative: Behr-Wenning, Gregor

(57) **Abstract**

The present invention provides a charging assembly (100) for an electric vehicle, the assembly (100). The charging assembly (100) includes a charger (110) and a protection module (130). The charger (110) for charging a battery of an electric vehicle. The protection module (130) is arranged within a housing (150) of the charger (110) and positioned over a primary PCB (120). The protection module (130) includes one or more protection elements configured to interrupt the input in the event of a fault condition, thereby preventing damage to the charger (110) and the electric vehicle's battery. The protection module (130) is detachably installed and replaceable independently of the charger (110).

## Description

### Field of the invention

The present invention relates to electric vehicle (EV) charging systems. Specifically, the present invention relates to a charging assembly for an electric vehicle.

### Background of the invention:

Electric vehicles (EVs) are increasingly becoming the preferred mode of transportation due to their environmental benefits and the shift toward renewable energy sources. One of the important components of any electric vehicle is its charger, which converts the alternating current (AC) supplied by the power grid into direct current (DC) to charge the vehicle's battery. This conversion process is required for charging, as the battery in an EV can only store DC energy.

Converting AC to DC requires the charger to work efficiently while also being protected from electrical hazards like voltage spikes, power surges, and over voltages from the grid. Without proper protection, these issues can damage the charger's electronics and the vehicle's battery.

As a result, chargers usually incorporate protection devices like fuses, varistors etc. These components are intended to safeguard the charging assembly by interrupting the flow of current or absorbing excess voltage in the event of a fault. The fuses, in particular, are designed to blow and disconnect the charging assembly when an overcurrent occurs, while varistors protect against voltage surges.

While chargers typically include protection mechanisms, existing solutions have several limitations. For example, in many current systems, replacing a failed protection device like a fuse is difficult because they are often bolted or soldered in place. This means a significant portion of the charger needs to be dismantled, and in some cases, the entire charger has to be replaced. This leads to high repair costs and long downtimes for the vehicle owner.

Many protection circuits are buried deep within the charger, making it harder for service personnel to diagnose or replace damaged components, increasing maintenance time and costs. Current designs use bolted connectors for the protection components, which are difficult to service and require special tools for removal. These bolted connections also risk loosening due to vibration, leading to electrical contact issues or failure during vehicle operation.

As EV technology advances, there is a need for chargers to meet higher protection standards against environmental factors like dust and water. However, prior designs do not efficiently meet these standards, often making manufacturing more complex or reducing environmental protection. Bolted connections, for example, can allow contaminants to enter, causing corrosion or electrical issues.

Therefore, there is a requirement for a charger assembly that addresses these drawbacks and can completely or partially overcome the drawbacks associated with the prior art solutions.

### Objects of the invention

An object of the present invention is to provide a charging assembly for an electric vehicle that allows the protection module to be easily replaced, reducing repair costs and time when protection components fail.

Another object of the present invention is to provide a charging assembly for an electric vehicle that uses press-fit power studs to connect the protection module, making assembly and maintenance easier compared to bolted or soldered connections.

One more object of the present invention is to provide a charging assembly for an electric vehicle that makes it easier for technicians to access and replace protection components, improving maintenance and reducing downtime.

Still an object of the present invention is to provide a charging assembly for an electric vehicle that is scalable, allowing the same modular protection design to be used across different charger power levels for various electric vehicles.

### Summary of the invention:

According to the present invention, there is provided a charging assembly for an electric vehicle. The charging assembly includes an charger, an AC input connector, a primary printed circuit board and a protection module. The charger is configured to convert alternating current (AC) input to direct current (DC) output for charging a battery of an electric vehicle. The AC input connector is coupled to the charger, configured to provide an AC supply to the charger. The primary printed circuit board is housed within the charger and configured to control power conversion and charging functions.

The protection module is arranged within a housing of the charger. The protection module is positioned over the primary PCB. The protection module includes a secondary printed circuit board (secondary PCB) arranged between the AC input connector and the primary PCB. The secondary printed circuit board is detachably connected to the primary PCB through a plurality of power studs. Each power studs are configured to provide both mechanical and electrical connections between the secondary PCB and the primary PCB.

The secondary PCB includes at least one fuse that passes the Neutral and Phase input through the fuses and routes it to the primary PCB such that in the event of a surge, the fuse trips/blows to stop the current flow to the primary PCB, protecting the primary PCB from damage.

In an aspect, the secondary PCB may include at least two fuses, varistors and a gas discharge tube (GDT). The fuses are arranged serially along the Phase (L) and Neutral (N) lines of the AC input, wherein a first fuse is connected to the Phase (L) input and a second fuse is connected to the Neutral (N) input.

In an aspect, the varistors may be arranged across the electrical lines to protect the charging assembly from voltage surges, wherein a first varistor is connected between the Phase (L) line and Earth (PE), a second varistor is connected between the Neutral (N) line and Earth (PE) and a third varistor is connected between the Phase (L) and Neutral (N) lines.

In an aspect, the gas discharge tube (GDT) may be connected between the Earth (PE) line and both the Phase (L) and Neutral (N) lines, the gas discharge tube (GDT) is configured to provide protection from extreme voltage surges by diverting excess voltage to ground.

In an aspect, the first fuse (F1) is serially connected to a first varistor (D1) and a third varistor (D3) on the secondary PCB. The second fuse (F2) is serially connected to a second varistor (D2) on the secondary PCB. The third varistor (D3) is serially connected to the second varistor (D2) on the secondary PCB. The varistors (D1, D2, D3) and the fuses (F1, F2) are serially connected to the gas discharge tube (GDT) on the secondary PCB, and the fuses, varistors, and gas discharge tube are detachably installed on the secondary PCB.

In an aspect, the power studs are elongated members adapted to connect between the primary printed circuit and the secondary printed circuit board, the power studs include a knurled section at one of its ends wherein the knurled section of the power studs is positioned to be press-fitted into a corresponding slot in the Primary PCB.

In an aspect, three power studs are configured to carry unprotected AC input current (Phase, Neutral, and Earth) from the AC input connector to the protection module on the secondary PCB, and two power studs are configured to carry the protected current from the secondary PCB to the primary PCB after being processed by the protection components.

In an aspect, a first power stud carries the Phase (L) input from the AC input connector to the protection module, a second power stud carries the Neutral (N) input from the AC input connector to the protection module and a third power stud carries the Earth (PE) input from the AC input connector to the gas discharge tube (GDT) in the protection module

In an aspect, a fourth power stud carries the protected Phase (L) current to the primary PCB and a fifth power stud carries the protected Neutral (N) current to the primary PCB.

Further, the housing of the protection module provides protection against environmental factors such as dust, water, and vibration, ensuring the components inside the protection module are protected from environmental contaminants.

In an aspect, the protection module is detachably installed and replaceable independently of the charger, allowing for replacement of the secondary PCB in the event of component failure without requiring replacement of the entire charging assembly.

In an aspect, a method of replacing the secondary PCB from the protection module of the charging assembly is provided. At first, a cover of the housing containing the secondary PCB and other fuse components are removed to access the secondary PCB. Next, disconnecting wires from power studs on the secondary PCB. Now removing the secondary PCB from the charger housing. Then installing a new secondary PCB and reconnecting the wires to the power studs. Finally reattaching the cover of the housing. By doing so, if a failure occurs, the protection module can be serviced or swapped out without needing to replace the entire charger, reducing maintenance costs and improving the operational uptime of the vehicle.

### Brief description of drawings

The advantages and features of the present invention will be understood better with reference to the following detailed description and claims taken in conjunction with the accompanying drawings, wherein like elements are identified with like symbols, and in which:
Figure 1 shows a schematic representation of a charging assembly for an electric assembly in accordance with the present invention;
Figure 2 illustrates a perspective view of the arrangement of a protection module on a primary PCB of the charging assembly;
Figure 3 illustrates a side view of the arrangement of secondary PCB on the primary PCB of the charging assembly;
Figure 4 illustrates the circuit diagram showing the configuration of protection components such as fuse, varistors and gas discharge tube on the secondary PCB of the protection module;
Figure 5 illustrates a schematic arrangement of charging assembly showing the arrangement of protection module within a covered housing;
Figure 6 illustrates the schematic view showing the pin terminals connecting the secondary PCB while disassembling the secondary PCB;
Figure 7 illustrates the removal and reattachment of pin terminals on a new secondary PCB;
Figure 8 illustrates a complete connection of pin terminals with the power studs using a screw arrangement and a clip arrangement from a central pin terminal; and
Figure 9 illustrates the protection module within a covered housing after attaching the new secondary PCB.

### Detailed description of the invention

An embodiment of this invention, illustrating its features, will now be described in detail. The words "comprising," "having," "containing," and "including," and other forms thereof, are intended to be equivalent in meaning and be open-ended in that an item or items following any one of these words is not meant to be an exhaustive listing of such item or items, or meant to be limited to only the listed item or items.

The terms "first," "second," and the like, herein do not denote any order, quantity, or importance, but rather are used to distinguish one element from another, and the terms "a" and "an" herein do not denote a limitation of quantity, but rather denote the presence of at least one of the referenced items.

The present invention relates to a charging assembly for electric vehicles that converts alternating current (AC) from the grid into direct current (DC) to charge the vehicle's battery. The assembly is housed in a protective enclosure to shield it from dust, water, and vibrations. The charging assembly is configured in such a way that, it can be easily maintained and allows for quick repairs and minimizes the downtime. The charging assembly ensures safe and reliable performance, making it suitable for various electric vehicle applications.

The disclosed embodiments are merely exemplary of the invention, which may be embodied in various forms.

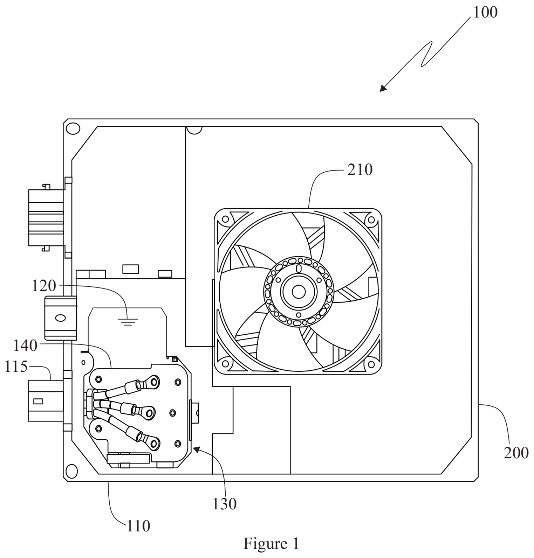

Referring now to figure 1, a schematic representation of a charging assembly for an electric vehicle in accordance with the present invention is provided. The charging assembly is used to convert alternating current (AC) from the grid into direct current (DC) to charge the vehicle's battery. The charging assembly is arranged within an enclosure (200) that provides protection from environmental factors such as dust, water, and vibration. A cooling fan (210) is mounted on the top of the enclosure, ensuring that the charging assembly operates within safe temperature limits during the charging process. The charging assembly is herein after referred as assembly (100).

The assembly (100) includes a charger (110), a primary printed circuit board (PCB) (120) and a protection module (130). In the present embodiment, the charger (110) is an onboard charger configured to convert an alternating current (AC) input to a direct current (DC) output for charging the battery of the electric vehicle. While this embodiment describes an AC-to-DC conversion, the charger (110) is not restricted to this configuration and may also perform DC-to-DC conversion. Furthermore, the assembly structure can accommodate either onboard or off-board chargers, depending on the application. The charger (110) is arranged within a base of the enclosure (200) and supports the primary PCB (120) and the protection module (130). Specifically, the charger (110) is integrated into the base of the enclosure, which provides a foundation for mounting other components, such as the primary PCB (120) and the protection module (130). In the present embodiment, the charger (110) supports the primary PCB (120), which facilitates in managing the power conversion and control functions of the charging assembly (100). The primary printed circuit board (120) is housed within the charger (110) and configured to control power conversion and charging functions. Specifically, the primary PCB (120) interfaces directly with the charger (110), receiving the AC input, processing it, and controlling the DC output to the battery.

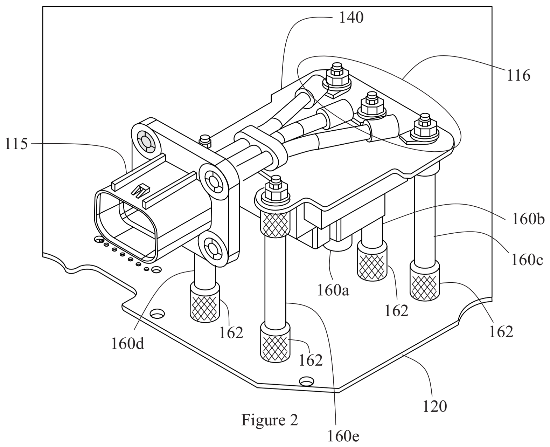

Referring now to figure 2, an AC input connector is interfaced between the power grid and the charger (110). The AC input connector (115) is arranged on a side portion of the charging assembly (100), as shown in the figure 2, allowing access for an external power cable. The AC input connector (115) may include multiple pin terminals (116) to connect the incoming AC power to the charger (110). Each pin corresponds to one of the main electrical lines: Phase (L), Neutral (N), and Earth (PE). The pins are insulated and color-coded to ensure correct and safe installation.

After the AC input is received through the AC input connector (115), the Phase (L) and Neutral (N) lines are directed to the protection module (130). The electrical current passes through protective components inside the protection module (130) to protect the charging assembly (100) against surges, overcurrent, and other electrical faults. Once the power passes through the protection module (130), the AC input is then transmitted to the charger (110), which does the AC-to-DC conversion. The charger (110) regulates the charging process, and ensures that the converted DC power is delivered to the battery of the vehicle.

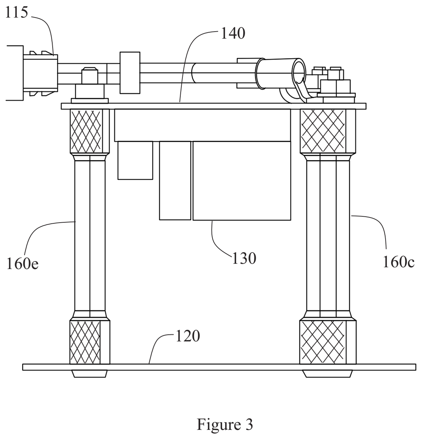

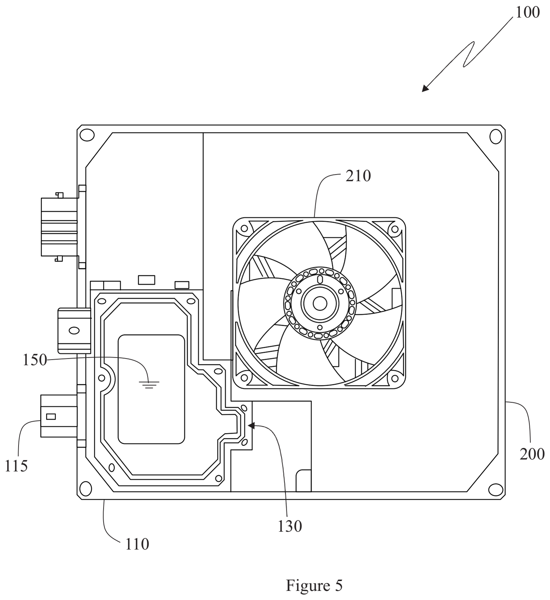

Referring now to figure 5, the protection module (130) is arranged within a housing (150) of the charger (110) and positioned over the primary PCB (120). The housing (150) ensures that the components inside the protection module (130) are protected from environmental contaminants like dust and moisture, which could otherwise lead to corrosion or failure of the electrical contacts. The protection module (130) includes one or more protection elements configured to protect the charger (110) from electrical surges and thermal events. In the present embodiment as shown in figures 2 and 3, the protection module (130) includes a secondary printed circuit board (140) having atleast one fuse and other preinstalled protection components to protect the primary PCB (120) and the charger (110) from electrical surges and thermal events by interrupting the AC input upon detecting a fault condition. The fault condition refers to a condition where the current exceeds a certain threshold due to a fault, short circuit, or overcurrent event and the like.

Referring now to figure 3, the secondary printed circuit board (140) (secondary PCB) is arranged between the AC input connector (115) and the primary PCB (120) and is detachably connected to the primary PCB (120) through a plurality of press-fit power studs (160a, 160b, 160c, 160d, 160e). The secondary PCB (140) includes at least one fuse that passes the Neutral and Phase input from the AC input connector (115) through the fuses and routes it to the primary PCB (120) such that in the event of a surge, the fuse trips/blows to stop the current flow to the primary PCB (120), protecting the primary PCB (120) from damage.

In the present embodiment, the protection module (130) includes components such as fuses, varistors, and gas discharge tube which are detachably installed on the secondary PCB (140). These components provide layered protection for the charger (110) and the vehicle's battery. The Fuses protect against excessive current flow. The varistors absorb and divert voltage surges and the GDT protects against extreme voltage events by grounding excess energy.

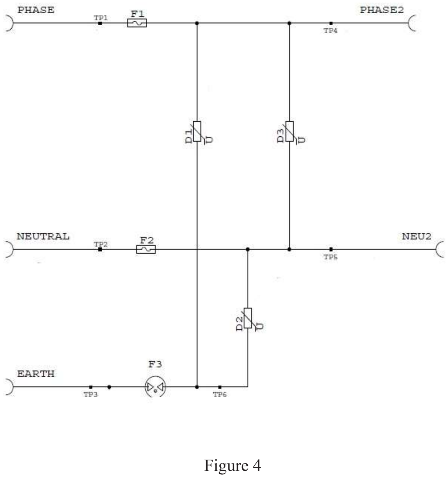

Specifically in the present embodiment as shown in figure 4, two fuses (a first fuse F1, a second fuse F2), three varistors (first varistor D1, second varistor D2 and third varistor D3) and a gas discharge tube is detachably connected to the secondary PCB (140). By way of non-limiting example, the fuses are positioned serially along the Phase (L) and Neutral (N) lines of the AC input. Specifically, the first fuse (F1) is serially connected to a first varistor (D1) and a third varistor (D3) on the secondary PCB (140). The second fuse (F2) is serially connected to a second varistor (D2) on the secondary PCB (140). When the AC input current flows through the Phase (L) and Neutral (N) lines, the current first passes through Fuses F1 and F2, respectively. Under normal conditions, the fuses allow current to pass through. However, if the current exceeds a certain threshold (due to a fault, short circuit, or overcurrent event), the fuses will "trip/blow," and break the circuit and stop the flow of current to the charger (110). This interrupts the power supply to the charger, protecting the components downstream from being damaged by excessive current.

The varistors are arranged across the electrical lines to protect the assembly (100) from voltage surges. The first varistor (D1) is placed between the Phase (L) and Earth (PE). The second varistor (D2) is placed between the Neutral (N) and Earth (PE). The third varistor (D3) is placed between the Phase (L) and Neutral (N). The third varistor (D3) is serially connected to the second varistor (D2) on the secondary PCB (140). The varistors (D1, D2, D3) are used to protect the assembly (100) from high-voltage surges or spikes that may result from external events like lightning strikes, power grid fluctuations, or other voltage anomalies. The first varistor (D1) diverts excess voltage from the Phase (L) line to Earth (PE). The second varistor (D2) performs a similar function for the Neutral (N) line, diverting any voltage spikes in the Neutral line to Earth (PE). The third varistor (D3) operates between the Phase (L) and Neutral (N) lines, absorbing surges between these lines.

The varistors (D1, D2, D3) and the fuses (F1, F2) are serially connected to the gas discharge tube (F3) on the secondary PCB (140). The Gas Discharge Tube (GDT - F3) is placed between the Earth (PE) line and both the Phase (L) and Neutral (N) lines. The GDT is provided to protect the assembly (100) from extreme voltage surges, higher voltage events that exceed the capacity of the varistors. These events can occur during severe lightning strikes or power grid faults that create high voltages. The GDT operates by ionizing the gas inside its sealed enclosure when exposed to very high voltages. Once the gas ionizes, the GDT becomes conductive, creating a low-resistance path for the excess voltage to be diverted to the ground (via the Earth line). This ensures that the excess energy from the surge is safely grounded, preventing damage to the charger (110) and the primary PCB (120). The GDT remains non-conductive under normal voltage levels and only activates during extreme overvoltage events for protection against voltage surges.

Under normal conditions, the AC current flows through the Fuses (F1 and F2) and continues to the charger (110). The varistors (D1, D2, D3) remain inactive, as the voltage remains within normal operating limits, and the GDT remains non-conductive. If there is an overcurrent (for example, due to a short circuit or fault in the system), the fuses (F1 and F2) will "trips/blow," breaking the circuit and preventing excessive current from reaching the charger (110). This ensures that the charger and the vehicle's battery are protected from damage.

If a voltage surge occurs (such as from a lightning strike or grid fluctuation), the varistors (D1, D2, D3) will become conductive, absorbing the excess voltage and diverting it to the ground via the Earth (PE) line. This prevents the surge from reaching the charger (110). If the voltage surge is extremely high, beyond the capacity of the varistors, the Gas Discharge Tube (GDT - F3) will ionize, creating a low-resistance path for the surge to be diverted to ground.

Once the AC current has passed through the fuses, varistors, and GDT, the current is delivered to the primary PCB (120) (main PCB) through the plurality of power studs connected between the secondary PCB (140) (Fuse PCBA) and the primary PCB (120) as shown in figures 2 and 3. The power studs ensure that only protected current reaches the primary PCB (120), reducing the risk of damage to the charger (110) and its components.

The power studs (160a, 160b, 160c, 160d, 160e) are components that provide both mechanical support and electrical connectivity between the Secondary PCB (140) (Fuse PCBA) and the primary PCB (120). Referring now to figures 2 and 3, the power studs (160a, 160b, 160c, 160d, 160e) are elongated members adapted to connect between the primary printed circuit and the secondary printed circuit board (140). The current flows through the power studs (160d, 160e) after passing through the protection components, ensures that only protected and protected current reaches the primary PCB (120). In an aspect, the power studs (160a, 160b, 160c, 160d, 160e) are constructed from a conductive metal, such as copper or brass, which provides electrical conductivity as well as strength and durability for mechanical connections. It may be obvious to a person skilled in the art to use any other material for constructing the power studs (160a, 160b, 160c, 160d, 160e).

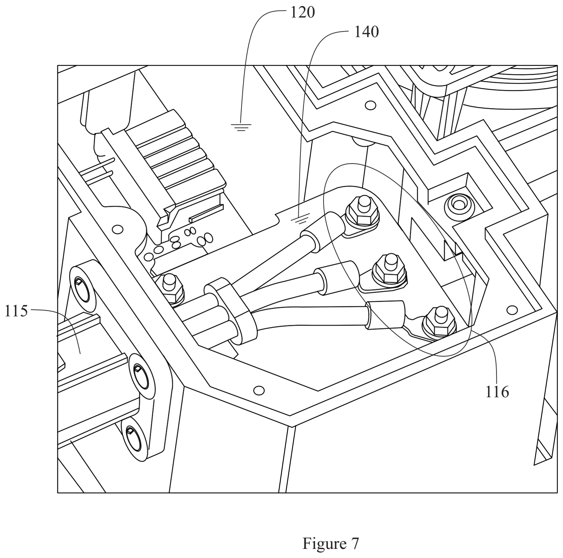

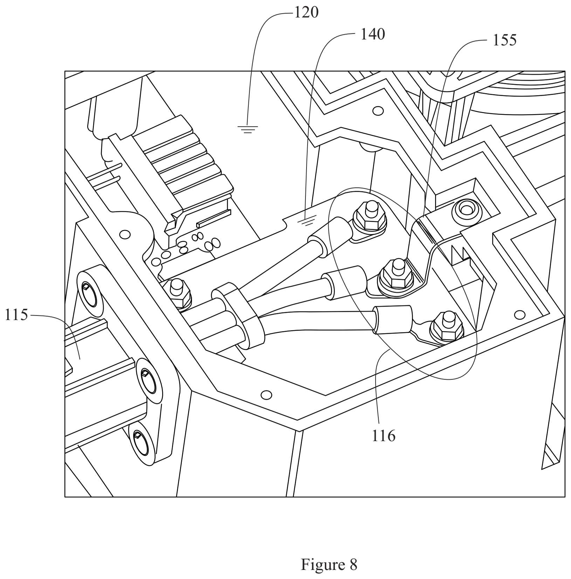

Each power stud (160a, 160b, 160c, 160d, 160e) is provided with a knurled section (162) along part of its cylindrical body. Specifically, each of the power studs (160a, 160b, 160c, 160d, 160e) include the knurled section (162) at one end wherein the knurled section (162) of the power studs (160a, 160b, 160c, 160d, 160e) is positioned to be press-fitted into a corresponding slot in the Primary PCB (120) . The knurled section (162) is configured to improve the mechanical engagement between the power studs (160a, 160b, 160c, 160d, 160e) and the primary printed circuit board (120). The other end of the power studs (160a, 160b, 160c, 160d, 160e) are connected to the secondary PCB (140) using a fastener, preferably using a screw arrangement as shown in figures 7 and 8.

The knurled section (162) of each power stud (160a, 160b, 160c, 160d, 160e) is positioned to be press-fitted into corresponding slots in the primary PCB (120). The knurled section (162) may consist of a textured pattern of ridges, which improves friction between the power studs (160a, 160b, 160c, 160d, 160e) and the primary PCB (120), providing a mechanical grip to prevent loosening due to vibrations, thermal expansion, or mechanical stress, which are common in electric vehicle environments. In an aspect, the diameter of the knurled section (162) is larger than the corresponding holes in the primary PCB (120), allowing for a press-fit connection when the power stud (160a, 160b, 160c, 160d, 160e) is inserted. The press-fit arrangement of the power studs (160a, 160b, 160c, 160d, 160e) allows them to be securely connected without the need for soldering or bolting, making the assembly (100) easier to manufacture and maintain.

In the present embodiment as shown in figure 2, five power studs (160a, 160b, 160c, 160d, 160e) are arranged to provide both mechanical support and electrical connectivity between the secondary PCB (140) and the primary PCB (120). Three power studs (160a, 160b, 160c) are used to carry the unprotected AC input current to the protection module (130), and two power studs (160d, 160e) carry the protected current to the primary PCB (120) after it has been processed by the components inside the protection module (130). Specifically, the multiple pin terminals (116) of the AC input terminal (115) are connected to the corresponding three power studs (160a, 160b, 160c). In the present embodiment, the pins are connected to a top portion of the power studs by a fastening arrangement such as a nut to pass the incoming AC power to the charger (110) as shown in figure 2.

The three power studs such as a first power stud (160a), a second power stud (160b) and a third power stud (160c) are arranged at one side portion of the secondary PCB (140) connecting the primary PCB (120) carries the raw AC input current from the AC input connector (115) to the protection module (130) on the secondary PCB (140). Each of these studs (160a, 160b, 160c) is connected to one of the three electrical lines Phase (L), Neutral (N), and Earth (PE).

The first power stud (160a) carries the Phase (L) current from the AC input connector (115) to the secondary PCB (140). The Phase (L) input provides the AC current that is transmitted through the first power stud (160a) directly to the protection components. It passes through the first fuse (F1) on the secondary PCB (140), which protects the assembly from overcurrent. If the fuse (F1) remains intact (i.e., no overcurrent event occurs), the Phase current continues to flow through the varistors (D1 and D3), which are placed to absorb any surge or spike in voltage. After passing through the protection components (fuse, varistor, GDT), the protected current is then passed to the fourth power stud (160d) and fifth power stud (160e) that send current to the primary PCB (120).

The second power stud (160b) carries the Neutral (N) current from the AC input connector (115) to the secondary PCB. The Neutral (N) input provides the return path for the AC current and flows through the second stud (160b) into the second fuse (F2) on the secondary PCB (140). The Neutral input is protected by the fuse (F2). If no overcurrent condition is detected, the Neutral current continues through the varistors (D2 and D3), which protect the assembly from voltage surges. Once the current is processed by the protection module (130), it flows to the fourth power stud (160d) and fifth power stud (160e), where it is sent to the primary PCB (120) for further processing.

The third power stud (160c) carries the Earth (PE) current from the AC input connector (115) to the Fuse PCBA. The Earth (PE) line is the grounding line and does not carry any active current under normal conditions. The Earth input flows through the third power stud to the Gas Discharge Tube (GDT) on the secondary PCB (140). The GDT only activates when there is a significant voltage surge or fault condition, creating a low-resistance path for the excess voltage to flow safely to ground. Under normal conditions, the Earth (PE) current passes through the GDT and remains unused unless there is a fault that requires grounding.

Once the AC current has passed through the protection module (130) (fuses, varistors, and GDT) on the secondary PCB (140), it is considered protected current, meaning it has been protected for any overcurrent or voltage surges. The two output power studs (fourth power stud (160d) and fifth power stud (160e)) carry the protected current to the primary PCB (120) for the AC-to-DC conversion process.

The fourth power stud (160d) carries the protected Phase (L) current from the secondary PCB (140) to the primary PCB (120). After the Phase (L) current has passed through Fuse F1 and the varistors (D1 and D3) on the Fuse PCBA, it flows through the fourth power stud to the primary PCB (120). The fourth power stud (160d) ensures that the Phase current reaching the primary PCB (120) is free of any voltage surges or overcurrent conditions, making it safe for further processing in the charger (110).

The fifth power stud (160e) carries the protected Neutral (N) current from the secondary PCB (140) to the primary PCB (120). Similar to the Phase (L) output stud, the fifth power stud (160e) carries the protected Neutral (N) current to the primary PCB (120). After passing through the fuse F2 and the varistors (D2 and D3) on the secondary PCB (140), the Neutral current flows through the fifth power stud (160e) to the primary PCB (120), ensuring that the neutral connection to the charger (110) is free from any faults or excess current.

Once the current reaches the primary PCB (120), the charger (110) converts the alternating current (AC) into direct current (DC), which is required to charge the electric vehicle's battery.

In the present embodiment, the protection module (130) is detachably installed and replaceable independently of the charger (110). This arrangement allows for replacement of the secondary PCB (140) in the event of component failure without requiring replacement of the entire charging assembly (100). In an aspect of the invention, a method of replacing the secondary PCB (140) from the protection module (130) of the charging assembly in accordance with the present invention is provided.

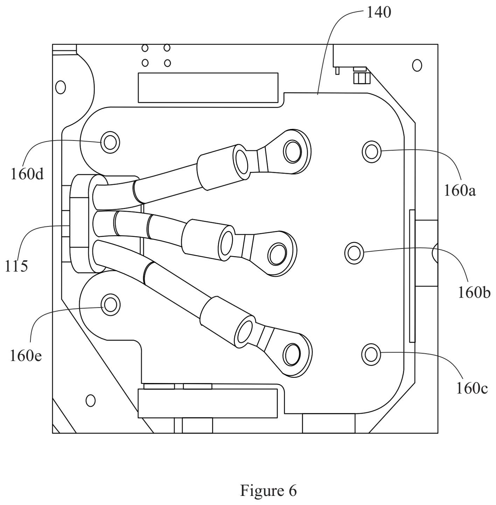

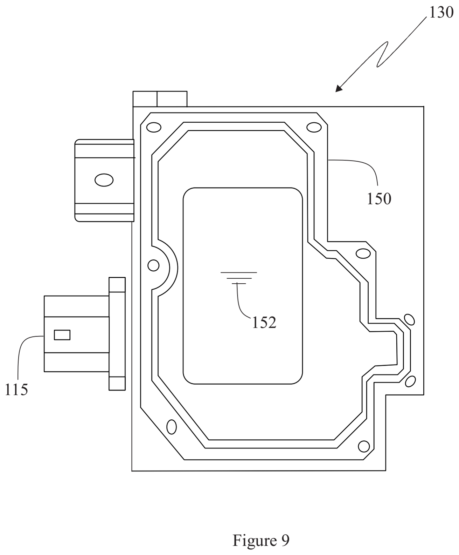

At first, a cover (152) of the housing (150) containing the secondary PCB (140) and other fuse components are removed to access the secondary PCB (140). Next, disconnecting wires from the power studs (160a, 160b, 160c, 160d and 160e) on the secondary PCB (140) as shown in figure 6. Now removing the secondary PCB (140) from the housing (150) by removing the screws attached with the power studs as shown in figure 7. Then installing a new secondary PCB (140) and reconnecting the wires to the power studs (160a, 160b, 160c, 160d and 160e) using screws and a clip arrangement (155) from the central terminal as shown in figure 8. Finally reattaching the cover (152) of the housing (150) as shown in figure 9. By doing so, if a failure occurs, the protection module (130) can be serviced or swapped out without needing to replace the entire charger (110), reducing maintenance costs and improving the operational uptime of the vehicle.

Therefore, the present invention provides an advantage of providing a charging assembly (100) for an electric vehicle which facilitates easy maintenance and replacement of the protection components through a detachable secondary PCB (140), allowing the protection module (130) to be serviced or replaced without requiring the entire charger assembly to be dismantled. The charging assembly improves mechanical stability and electrical connectivity between the secondary PCB (140) and the primary PCB (120) through the use of press-fit power studs, which provide secure connections, reducing the risk of disconnection due to vibration or mechanical stress. Also, the present invention reduces downtime and repair costs by enabling the replacement of individual protection components, such as fuses, without needing to replace the entire charger (110).

The foregoing descriptions of specific embodiments of the present invention have been presented for purposes of illustration and description. They are not intended to be exhaustive or to limit the present invention to the precise forms disclosed, and obviously, many modifications and variations are possible in light of the above teaching. The embodiments were chosen and described in order to explain the principles of the present invention best and its practical application, to thereby enable others skilled in the art to best utilise the present invention and various embodiments with various modifications as are suited to the particular use contemplated. It is understood that various omission and substitutions of equivalents are contemplated as circumstance may suggest or render expedient, but such are intended to cover the application or implementation without departing from the scope of the claims of the present invention.

## Claims

1. A charging assembly (100) for an electric vehicle, the assembly (100) comprising:
a charger (110) for charging a battery of an electric vehicle;
a protection module (130) arranged on/within a housing of the charger (110) and positioned over the primary PCB (120), the protection module (130) includes one or more protection elements configured to interrupt input in the event of a fault condition, thereby preventing damage to the charger (110) and the battery of the electric vehicle;
wherein the protection module (130) is replaceable independently of the charger (110).

2. The charging assembly (100) as claimed in claim 1 wherein the protection module (130) includes;
a secondary printed circuit board (140) (secondary PCB) arranged between an input connector (115) and the primary PCB (120) and is detachably connected to the primary PCB (120) through a plurality of power studs (160a, 160b, 160c, 160d and 160e), each power studs (160a, 160b, 160c, 160d and 160e) are configured to provide both mechanical and electrical connections between the secondary PCB (140) and the primary PCB (120);
wherein the secondary PCB (140) includes at least one fuse that passes the Neutral and Phase input through the fuses and routes it to the primary PCB (120) such that in the event of a surge, the fuse trips/blows to stop the current flow to the primary PCB (120), protecting the primary PCB (120) from damage.

3. The charging assembly (100) as claimed in claim 2, wherein the secondary PCB (140) includes at least two fuses (F1, F2), varistors (D1, D2, D3) and a gas discharge tube (GDT-F3), the fuses (F1, F2) are arranged serially along the Phase (L) and Neutral (N) lines of the input, wherein a first fuse (F1) is connected to the Phase (L) input and a second fuse (F2) is connected to the Neutral (N) input.

4. The charging assembly (100) as claimed in claim 3, wherein the varistors (D1, D2, D3) are arranged across the electrical lines to protect the assembly (100) from voltage surges, wherein a first varistor (D1) is connected between the Phase (L) line and Earth (PE); a second varistor (D2) is connected between the Neutral (N) line and Earth (PE); and a third varistor (D3) is connected between the Phase (L) and Neutral (N) lines.

5. The charging assembly (100) as claimed in claim 3, wherein the gas discharge tube (GDT-F3) is connected between the Earth (PE) line and both the Phase (L) and Neutral (N) lines, the gas discharge tube (GDT-F3) is configured to provide protection from extreme voltage surges by diverting excess voltage to ground.

6. The charging assembly (100) as claimed in claim 3, wherein;
the first fuse (F1) is serially connected to a first varistor (D1) and a third varistor (D3) on the secondary PCB (140);
the second fuse (F2) is serially connected to a second varistor (D2) on the secondary PCB (140); and
the third varistor (D3) is serially connected to the second varistor (D2) on the secondary PCB (140);
wherein the first, second, and third varistors (D1, D2, D3) and the fuses (F1, F2) are serially connected to the gas discharge tube (GDT-F3) on the secondary PCB (140), and the fuses, varistors, and gas discharge tube are detachably installed on the secondary PCB (140).

7. The charging assembly (100) as claimed in claim 2, wherein the power studs (160a, 160b, 160c, 160d and 160e) are elongated members adapted to connect between the primary printed circuit board (120) and the secondary printed circuit board (140), the power studs (160a, 160b, 160c, 160d and 160e) include a knurled section (162) at one end wherein the knurled section (162)of the power studs (160a, 160b, 160c, 160d and 160e) is positioned to be press-fitted into a corresponding slot in the Primary PCB (120).

8. The charging assembly (100) as claimed in claim 2, wherein three power studs (160a, 160b, 160c) are configured to carry unprotected input current (Phase, Neutral, and Earth) from the input connector (115) to the protection module (130) on the secondary PCB (140), and two power studs (160d, 160e) are configured to carry the protected current from the secondary PCB (140) to the primary PCB (120) after being processed by the components inside the protection module (130).

9. The charging assembly (100) as claimed in claim 8, wherein:
a first power stud (160a) carries the Phase (L) input from the input connector (115) to the protection module (130);
a second power stud (160b) carries the Neutral (N) input from the input connector (115) to the protection module (130);
a third power stud (160c) carries the Earth (PE) input from the input connector (115) to the gas discharge tube (GDT) in the protection module (130);
a fourth power stud (160d) for carrying the protected Phase (L) current to the primary PCB (120); and
a fifth power stud (160e) for carrying the protected Neutral (N) current to the primary PCB (120).

10. The charging assembly (100) as claimed in claim 1, wherein the housing (150) provides protection against environmental factors such as dust, water, and vibration, ensuring the components inside the housing (150) are protected from environmental contaminants.

11. The charging assembly (100) as claimed in claim 2, wherein the protection module (130) is detachably installed and replaceable independently of the charger (110), allowing for replacement of the secondary PCB (140) in the event of component failure without requiring replacement of the entire charging assembly (100).

12. The charging assembly (100) as claimed in claim 11, wherein a method of replacing the protection module (130) in the charging assembly (100) includes the steps of:
removing a housing cover (152) of the protection module (130) to access the secondary PCB (140);
disconnecting wires from the power studs (160a, 160b, 160c, 160d and 160e) on the secondary PCB (140);
removing the secondary PCB (140) from the charger housing (150);
installing a new secondary PCB (140) and reconnecting the wires to the power studs (160a, 160b, 160c, 160d and 160e); and
reattaching the housing cover (152).
